# EUROPEAN PATENT SPECIFICATION

(11) **EP 0 528 511 B1**
(45) Date of publication and mention of the grant of the patent: **17.06.1998**
(21) Application number: 92303634.7
(22) Date of filing: 23.04.1992
(51) Int. Cl.: G06F 15/80, H03M 1/00, H03M 1/34

(54) **Neural network quantizer**
Quantisierer mit neuronalem Netzwerk
Quantificateur à réseau neuronal

(30) Priority: 15.08.1991 US 744115
(43) Date of publication of application: 24.02.1993
(73) Proprietor: SONY CORPORATION, Tokyo 141 (JP); CALIFORNIA INSTITUTE OF TECHNOLOGY, Pasadena California 91125 (US)
(72) Inventor: Kobayashi, Seiji, c/o Patents Division, Shinagawa-ku, Tokyo 141 (JP); Psaltis, Demetri, c/o Dep. El. Eng., Mail Stop, Boulevard, Pasadena, California 91125 (US)
(74) Representative: Cotter, Ivan John

(56) References cited:
- US-A- 4 926 180
- US-A- 4 965 579
- IEEE TRANSACTIONS ON CIRCUITS AND SYSTEMS vol. 36, no. 1 , January 1989 , NEW YORK, NY, US pages 42 - 50 XP000098132 SMITH ET AL 'Practical Design and Analysis of a Simple "Neural" Optimization Circuit'

## Description

This invention relates to a neural network quantizer.

In the prior art, an analogue signal may be quantized (digitized) by a quantization method which utilises analogue-to-digital (A/D) conversion. In such a method, an input signal is sampled at intervals, the sampled values obtained are classified by amplitude, and values corresponding to classes of amplitude are output.

This method has the advantage that the apparatus is relatively simple, because the values are determined at intervals. Thus, characteristics in the frequency region are not considered. Such characteristics may include the noises generated by the quantization itself, which noises are concentrated at a specific frequency. In such apparatus, in order to make the concentrated noises appear inconspicuous, white noise is intentionally added.

In this method using A/D conversion signals, the signal lying in a frequency range from a DC component to 1/2 of the sampling frequency are uniformly weighted, and then converted. As a result, when a required signal exists only in one frequency band, the encoding efficiency is not satisfactory.

United States Patent US-A-4,926,180 discloses a neural network quantizer for use with a 1-bit non-standard analogue-to-digital converter utilizing weighted feedback to the neural network.

According to the present invention there is provided a neural network quantizer comprising:
a plurality of multi-level neurons each neuron being responsive to an input analogue signal to generate an output analogue value having one of a plurality of possible non-zero amplitude levels;
means for supplying respective sampled input analogue signals to respective ones of said neurons;
means for weighting said output analogue values by weighting coefficients to generate weighted analogue values;
means for feeding back each of said weighted analogue values from the respective one of said neurons to all of said neurons;
means for comparing the weighted analogue values fed back with the respective ones of said sampled input analogue signals and providing corresponding compared results; and
means for correcting the output values of said neurons in response to said compared results, so that, when the compared results are converged within a predetermined range, the output values of said neurons are produced to quantize said input analogue signals; characterised in that
said weighting coefficients correspond to a transformation from a frequency domain into a temporal domain of a band pass window function for a desired frequency band within said sampled input analogue signals.

The invention will now be described by way of example with reference to the accompanying drawings, throughout which like parts are referred to by like references, and in which:
Figure 1 is a block diagram of an embodiment of neural network quantizer according to the present invention;
Figure 2 is a block diagram of a multi-level neuron;
Figure 3 is a diagram showing the transfer function of a neuron;
Figure 4 is a waveform diagram of an input analogue signal;
Figure 5 is a frequency spectrum diagram of the input analogue-signal of Figure 4;
Figure 6 is a diagram of a window;
Figure 7 is a diagram of a weighting function calculated from the window of Figure 6;
Figure 8 is a diagram showing the level of the signal quantized by A/D conversion;
Figure 9 is a frequency spectrum diagram of the quantized signal of Figure 8;
Figure 10 is a diagram showing the level of a quantized signal;
Figure 11 is a frequency spectrum diagram of the quantized signal of Figure 10; and
Figure 12 is a graph of the change of the noise power.

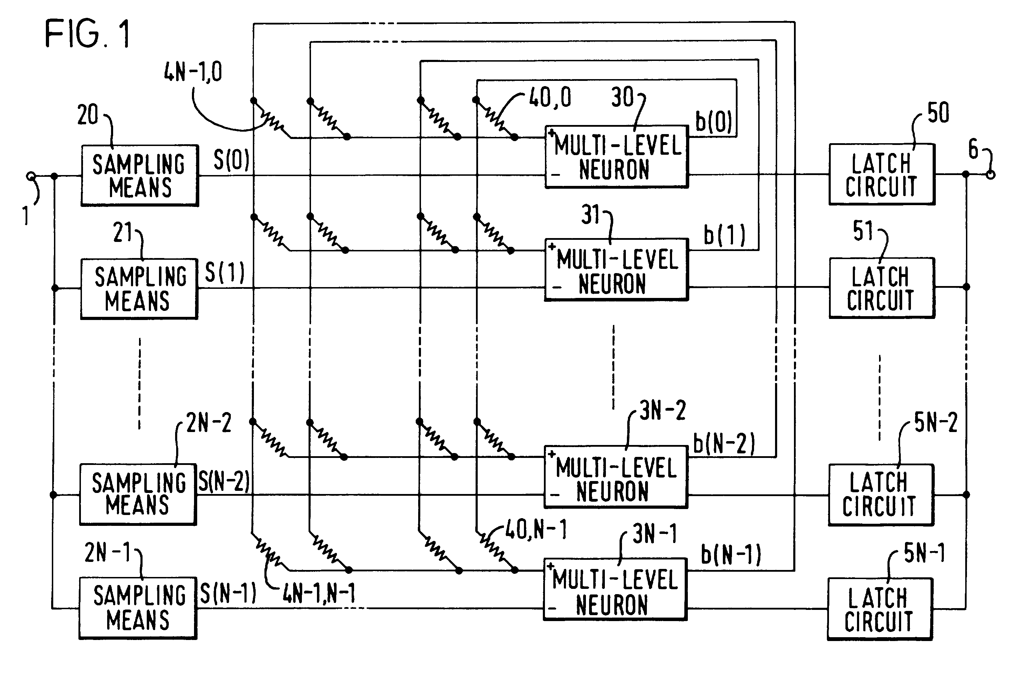

Referring to Figure 1, the embodiment comprises an analogue signal input terminal 1 through which an analogue input signal is supplied to sampling means 2₀ to 2_{N-1}, together with a sampling pulse which is sequentially supplied to the sampling means 2₀ to 2_{N-1}. As a result, N sampled values are extracted from the analogue sample by the sampling means 2₀ to 2_{N-1} and are respectively supplied to one input terminal of multi-level neurons 3₀ to 3_{N-1}, which will be described later.

Output values in analogue form from these neurons 3₀ to 3_{N-1} are respectively supplied through weighting resistors 4₀, ₀ ... 4₀, _{N-1} to 4_{N-1}, ₀ ... 4_{N-1}, _{N-1} to the other input terminal of the neuron 3₀ to 3_{N-1} supplying the respective value, and to the other input terminal of the other remaining neurons 3₀ to 3_{N-1}. Output values, in digital form, from the neurons 3₀ to 3_{N-1} are respectively supplied to latch circuits 5₀ to 5_{N-1} which latch the output values produced when the calculation by the neurons 3₀ to 3_{N-1} has finished. The above-described sampling pulse is supplied to the latch circuits 5₀ to 5_{N-1}, so as to cause the latched values to be sequentially supplied to an output terminal 6.

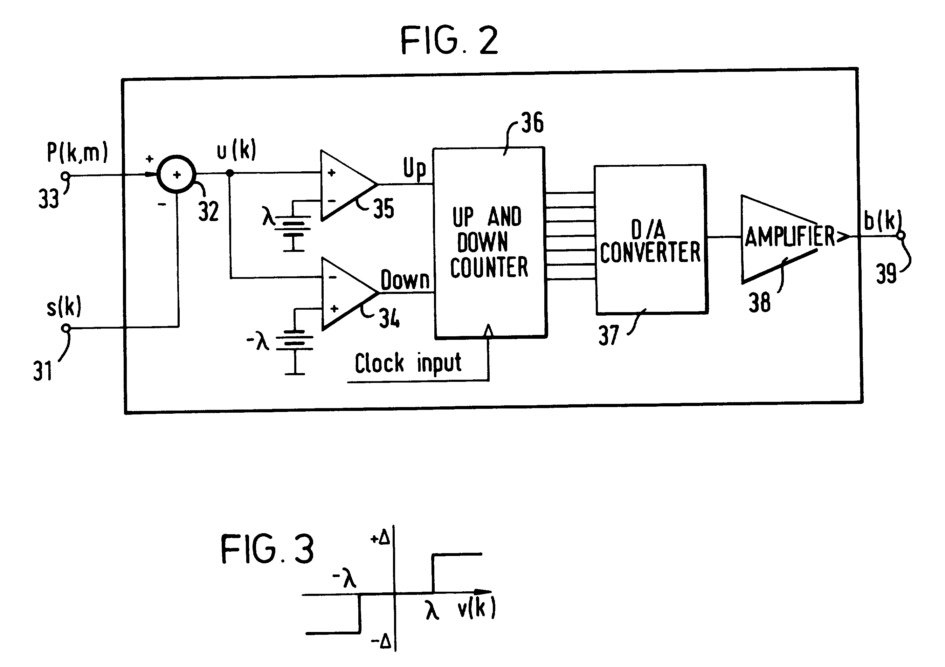

A multi-level neuron will now be more fully described with reference to Figure 2. As shown therein, a signal is supplied through one input terminal 31 to a subtracting input terminal of a subtracter 32, and a signal is supplied through another input terminal 33 to a positive input terminal of the subtracter 32. An output of the subtracter 32 is supplied to comparators 34 and 35 which respectively compare the level of the received output with levels of -λ and +λ, so as to obtain the levels less than -λ and more than +λ. Outputs of the comparators 35 and 34 are respectively supplied to up and down input terminals of an up and down counter 36.

An arbitrary clock signal is supplied to a clock input of the counter 36. A count value from the counter 36 is supplied to a digital-to-analogue (D/A) converter 37, whereupon the value is converted from digital to analogue form and supplied through an amplifier 38 having a predetermined amplification factor (xΔ), so as to obtain an analogue output value which is supplied to an output terminal 39. The count value from the counter 36 is further supplied therefrom as an output value in digital from (not shown).

Accordingly, as shown in Figure 3, when the output of the subtracter 32 (Figure 2) is less than -λ, the output value of the multi-level neuron is decreased by Δ, while when the output of the subtracter 32 is higher than +λ, the output value of the neuron is increased by Δ. When the output of the subtracter 32 falls within a range of ±λ in all the neurons 3₀ to 3_{N-1}, then the calculation has converged.

Referring again to the above neural network quantizer, the weighting coefficients associated with the resistors 4₀, ₀ ... 4_{N-1}, ₀ to 4₀, _{N-1} ... 4_{N-1}, _{N-1} are determined as follows.

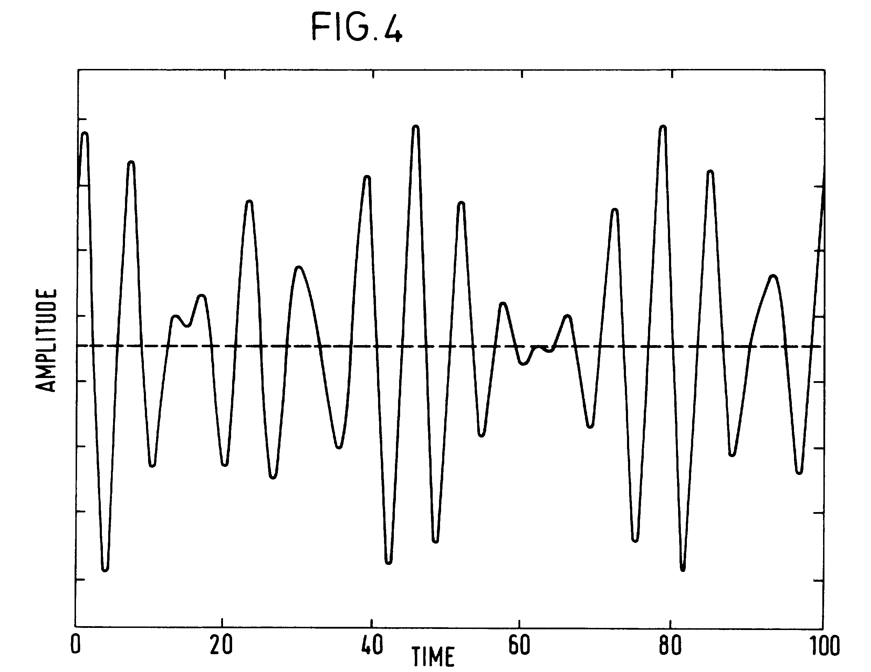

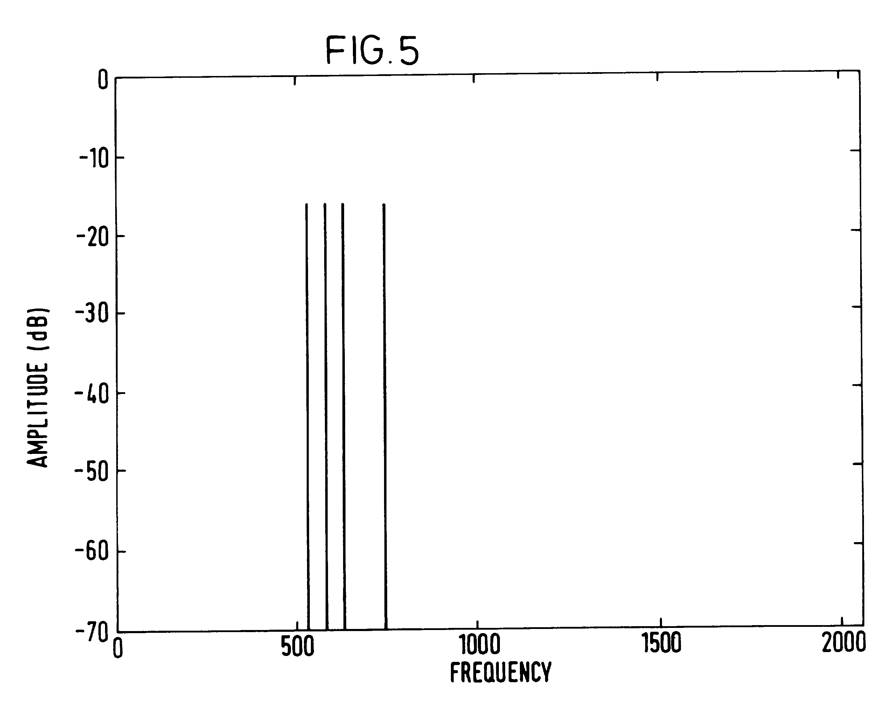

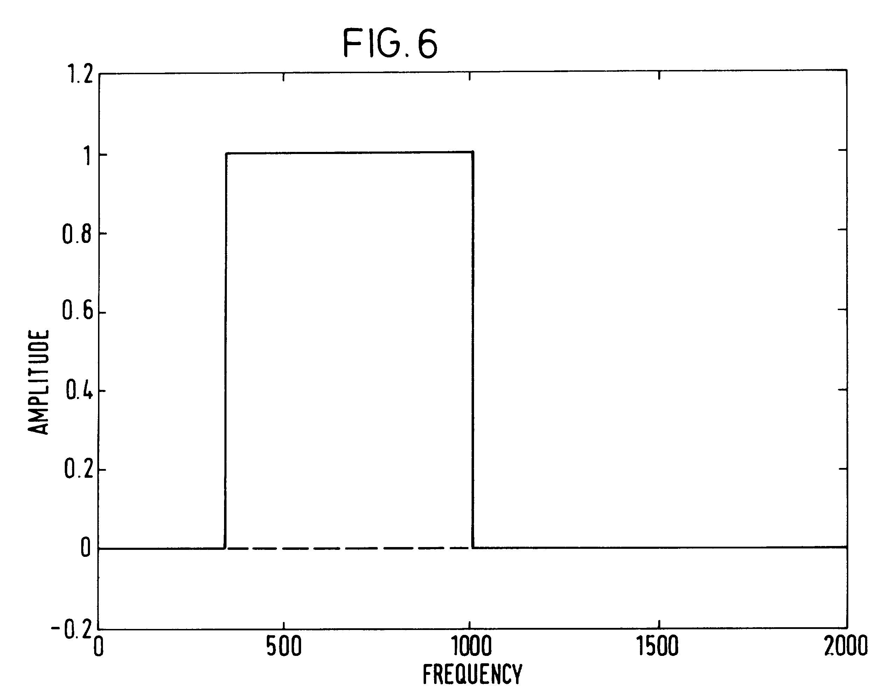

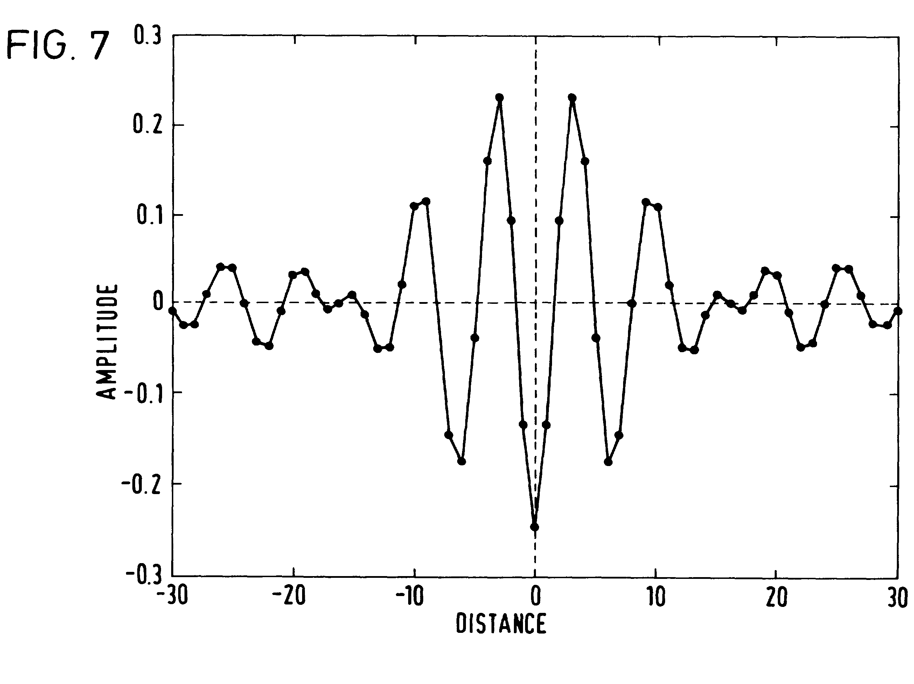

Consider the situation in which an input analogue signal as shown, for example, in Figure 4, which signal is composed of signals having four frequencies as shown in Figure 5, is quantized. As shown in Figure 6, a window may be provided which has a frequency band which includes these four frequencies and has an amplitude value of 1, and in which the other frequency bands have an amplitude value of 0. If the signals contained in this window are Fourier-transformed, the weighting coefficients (coupling coefficients) shown in Figure 7 may be obtained. The abscissa in Figure 7 indicates the distance between the neurons 3₀ to 3_{N-1} (this distance value results from subtracting the suffix numeral of the neuron which outputs a respective value from the suffix numeral of the neuron which receives the value). Also, negative weighting is obtained by respectively connecting the resistors 4₀, ₀ ... 4₀, _{N-1} to 4_{N-1}, ₀ ... 4_{N-1}, _{N-1} to the terminals 31 of the neurons 3₀ to 3_{N-1}. Thus, the weighting of the resistors 4₀, ₀ ... 4₀, _{N-1} to 4_{N-1}, ₀ ... 4_{N-1}, _{N-1} is determined to quantize the input analogue signal.

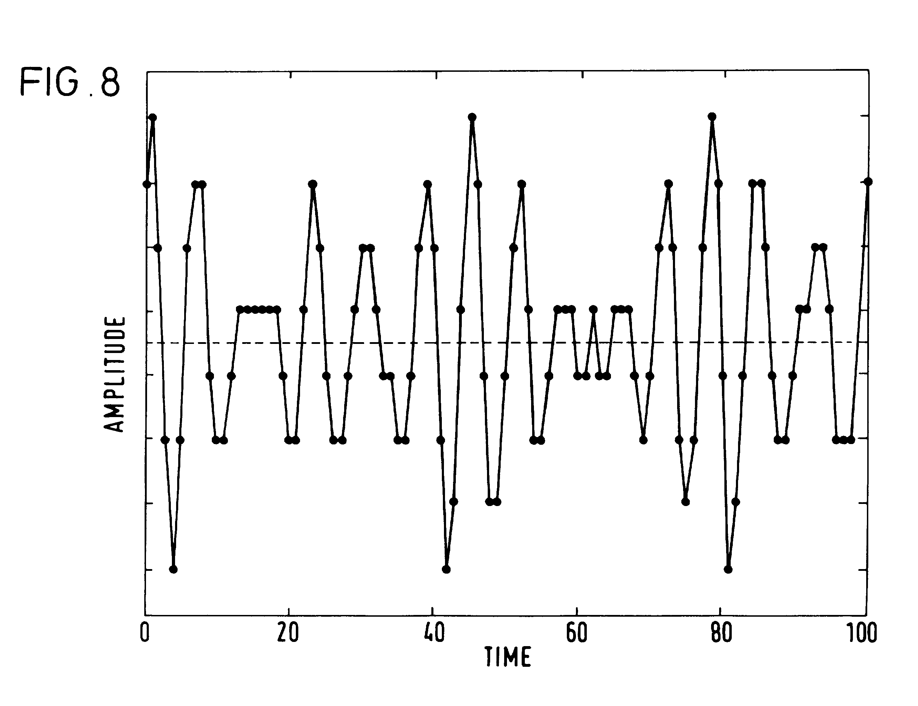

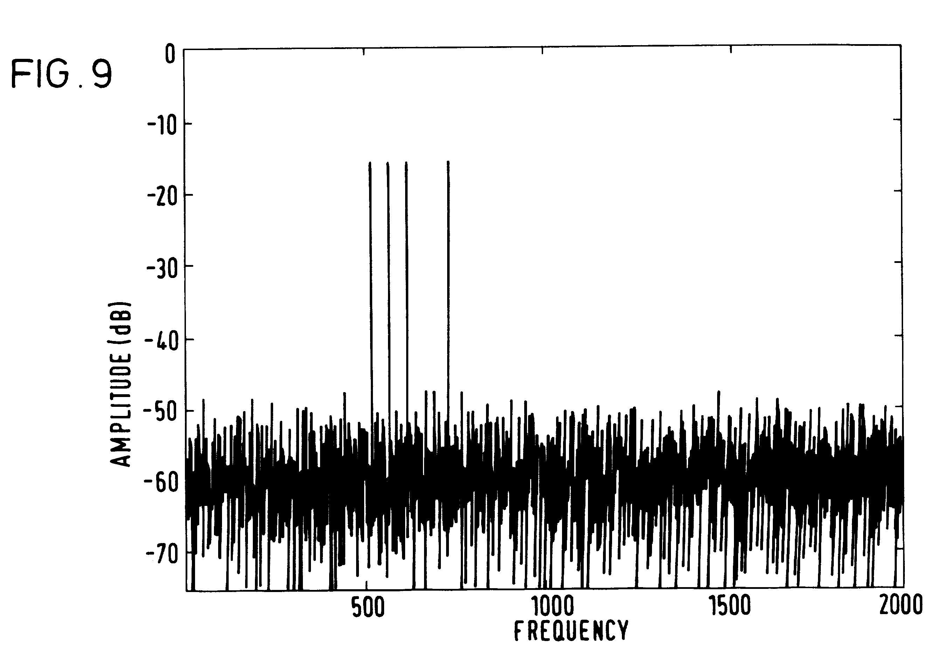

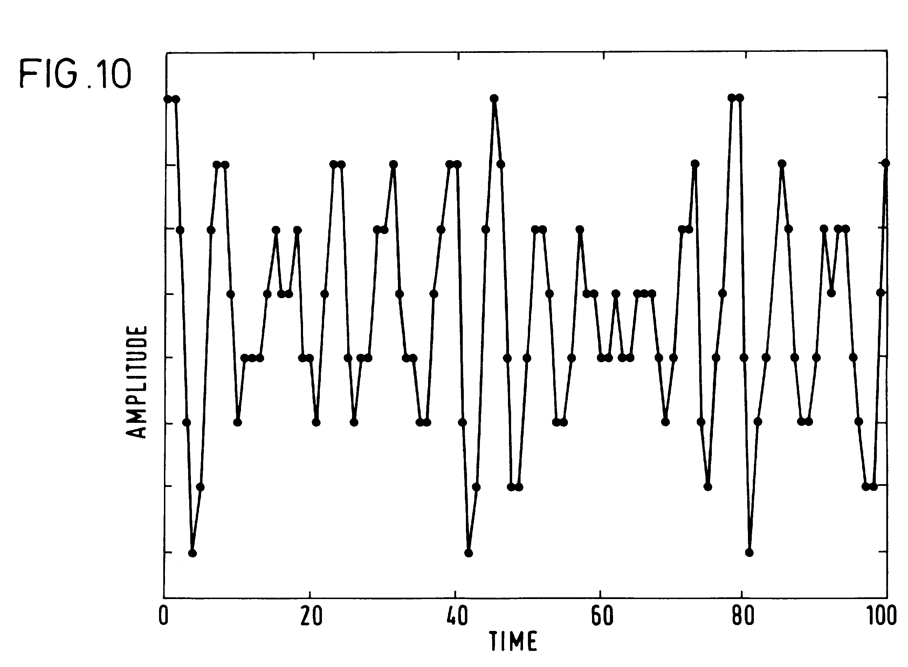

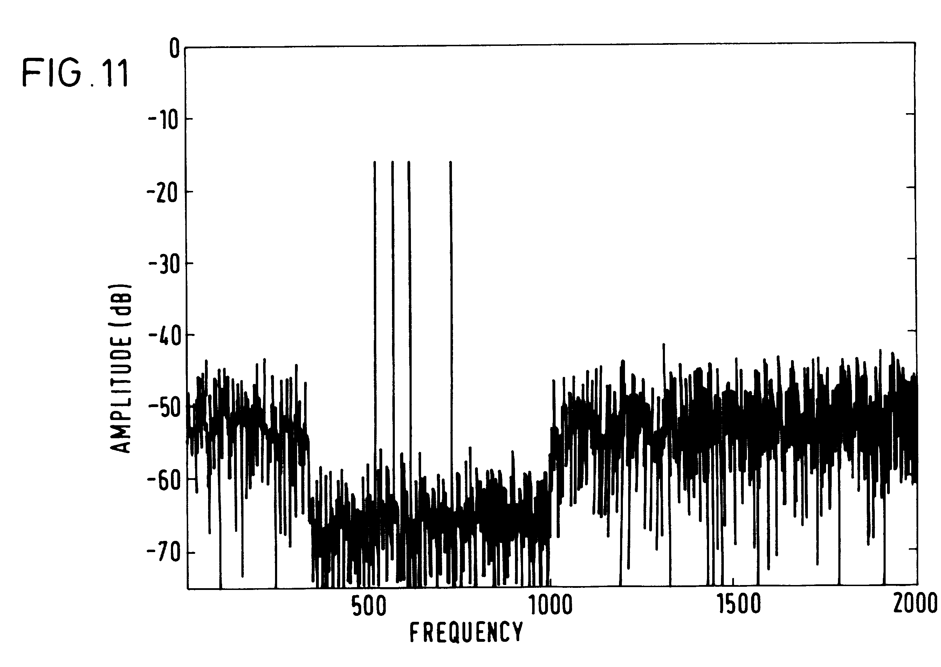

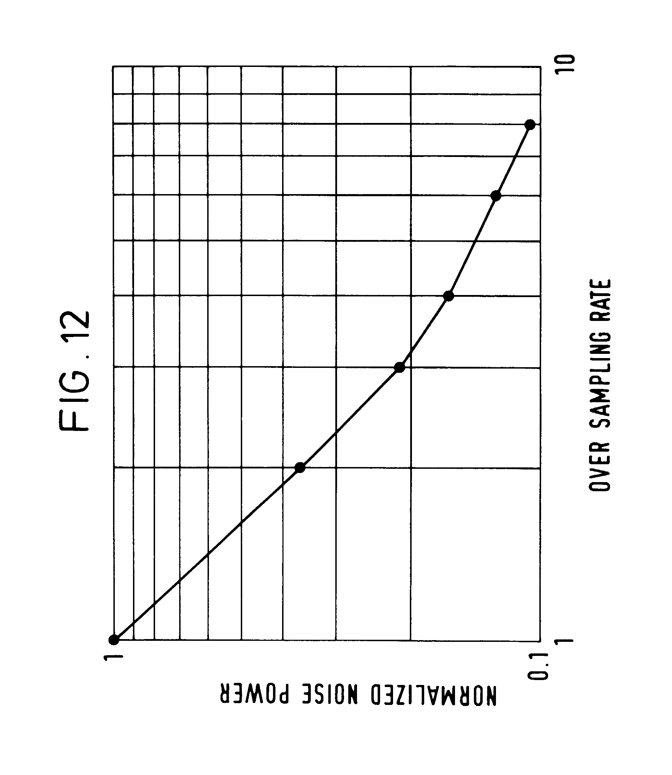

Quantization of the input analogue signal described above, may be performed by A/D conversion so as to obtain a quantized signal as shown in Figure 8. If this quantized value is converted using spectral analysis techniques so as to obtain the frequency spectrum, noise is produced throughout the entire spectrum as shown in Figure 9. On the other hand, if the input analogue signal is quantized by the above apparatus, then the quantized signal obtained is somewhat different from the original waveform as shown in Figure 10. However, if the resultant quantized value is converted using spectrum analysis techniques so as to obtain the frequency spectrum, as shown in Figure 11, the original four frequencies are obtained with a reduced noise level in the frequency band of the perviously defined window. Figure 12 shows how the noise power within the window is reduced as a function of the inverse ratio of the middle of the window relative to the width of the whole band. For example, if the width of the window is selected to be 1/8 of the whole band width, then the noise power can be reduced to about 0.1 of the noise power associated with a window having a width equal to the whole band. Likewise, if the width of the window is selected to be 1/2 of the whole band width, then the noise power can be reduced to about 0.35 of the noise power associated with a window having a width equal to the whole band.

The numbers on the axes of Figures 4 to 11 which do not have specific units identified therewith are provided so as to show relative values.

As described above, the input analogue signal supplied to the input terminal 1 is quantized and then fed to the output terminal 6. According to the above apparatus, when the input analogue signal is A/D-converted, the noise in the band defined as the window can be reduced so that good quantization can be effected.

More specifically, assume that g(t) represents an input signal, and that g(n) (n = 0, 1, ... N-1) represents a result obtained by sampling the input signal g(t) at a relatively high sampling frequency. Incidentally, g(t) may be an analogue signal stored in a sample and hold circuit or a digital signal quantized with high accuracy by a relatively high-accuracy A/D converter.

Further, assume that b(n) represents a quantized signal, in which b(n) may have M kinds of discrete values from -1 to +1.

In this situation, the above apparatus may be required to determine the signal b(n) such that the difference between the above original signal g(n) and the signal b(n) may be minimized after having been multiplied by a frequency window function W(k).

Accordingly, if a scaling factor determined by the apparatus is represented by α and if E represents an energy function, then the following equation is established: 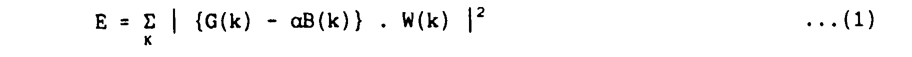 Thus, in the above situation, the signal b(n) is selected so that the energy function E may be minimized. In equation (1), G(k) and B(k) are Fourier transforms of the signals g(n) and b(n) respectively. Also, W(k) is the window function which designates the frequency region from which the noise is to be removed or reduced. For example, W(k) can be defined as

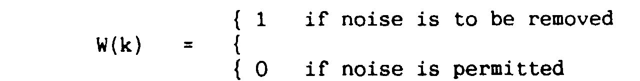

On the other hand, equation (1) may be converted into an equation in the time domain by Parseval's theorem, and by substituting the Fourier transform of W(k), that is, w(n), the following equation is produced: 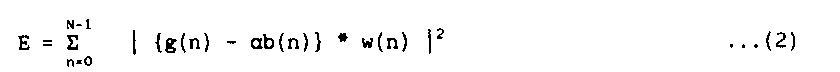 where * denotes convolution.

Further, if ĝ(n) represents the convolution between g(n) and the window function, the following expression may be obtained 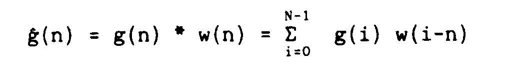 Thus, the following equation is established; 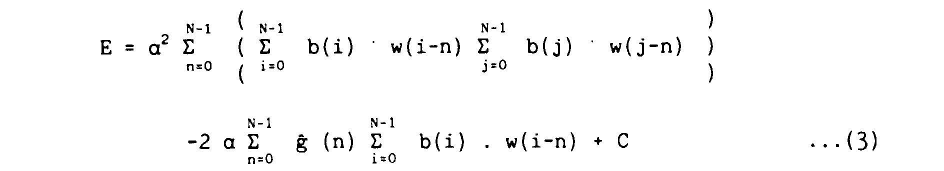 where C is a constant term that does not depend on b(n).

Further, exchanging the integrating order and the variable names results in the following equation: 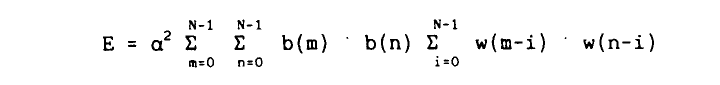 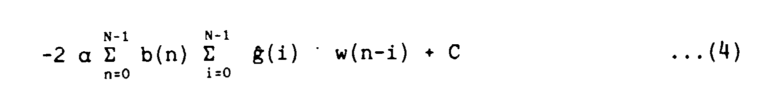 The terms P(m,n) and S(n) are defined as follows: 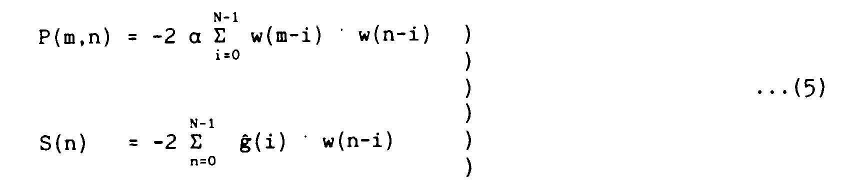 where P(m,n) is the auto-correlation of the Fourier transform of the window function, multiplied by the scaling factor α. Due to the properties of the auto-correlation function, and since the scaling factor α is positive, the following expressions are obtained:$\text{P(m,n) < 0}$$\text{P(m,n) = P(n,m)}$

Further, substituting the terms of equation (5) into equation (4) results in the following equation: 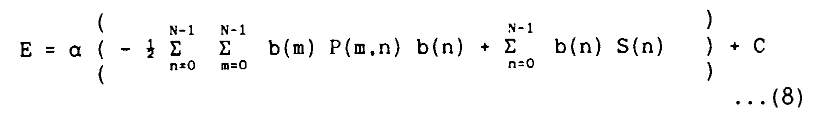 Because the term C is a constant term and, as a result, cannot be reduced or minimized, the value of b(n) is determined which minimizes the energy function E without the constant term C, which may be written as follows:

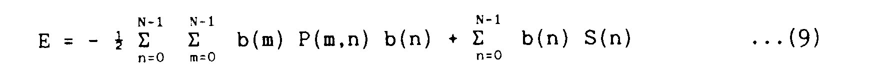

The above-described operation may be performed by the multi-level neural network using the multi-level neurons.

That is, in the above apparatus, each neuron can output discrete values from -1 to +1. Moreover, each of the neurons is respectively coupled by the weighting coefficient P(m,n), so as to form the multi-level neural network. Here, an input u(k) of the k'th neuron is formed from the sum of the outputs of the neurons and a threshold value s(k) of each neuron and may be expressed as:

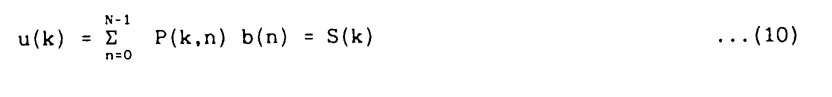

If the value of u(k) is larger than the dead zone ±λ, as shown in Figure 3, then the neuron changes its output by + or -Δ, respectively.

The output change at a timing point t + 1 can be expressed as follows:

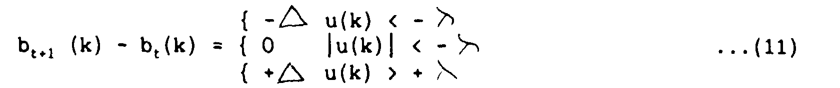

Here, the step change Δ and the width λ of the dead zone may be determined by the following expression:$\text{Δ =} \frac{\text{2}}{\text{M-1}}$$\text{λ =} \frac{\text{1}}{\text{2}} \text{Δ|P(k,k)|}$

In this case, however, the output of each neuron is saturated in a range from -1 to +1 so that, in actual practice, the output of the k'th neuron at the timing point t+1 may be expressed as follows:

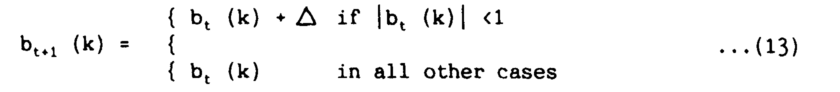

Moreover, the following discussion will show that the multi-level neural network described above operates with a relatively lower energy level E'.

Energy at timing point t is expressed as follows:

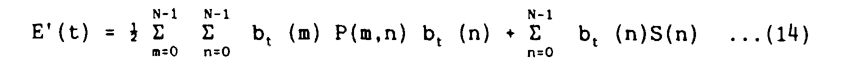

Then, the k'th neuron changes its outputs at the timing point t+1 in a manner similar to that defined by equation 13, that is, in accordance with the following equation: 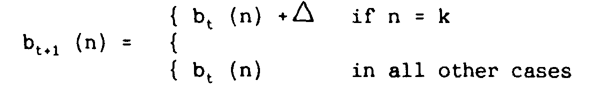 Calculating the energy at the timing point t + 1 by utilizing P(m,n) = P(n,m) which, as previously described, is a characteristic of the auto correlation function, results in the following expression:

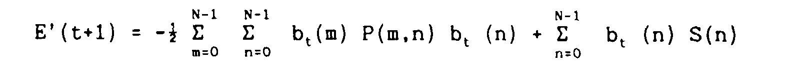

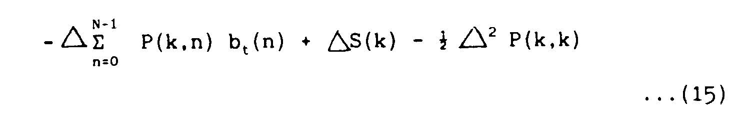

Accordingly, the difference between the energies of timing point t+1 and timing point t is expressed as follows:

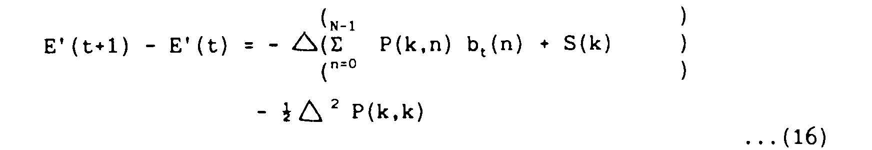

As is to be appreciated, if Δ = 0, then the energy of timing point t+1 has not changed from that of timing point t. Moreover, the change of energy in the case of Δ = 1 or Δ = -1 is readily available. For example, if Δ = 1, then the equation (10) yields:$\text{u(k) > -} \frac{\text{1}}{\text{2}} \text{P(k,k)}$

Substituting this relation into equation (16) results in the following equation:$\text{E'(t+1) - E'(t) = - Δ[u(k)] -} \frac{\text{1}}{\text{2}} {\text{Δ}}^{\text{2}} \text{P(k,k)} \text{< (} \frac{\text{1}}{\text{2}} \text{P(k,k)) -} \frac{\text{1}}{\text{2}} \text{P(k,k)}$ Thus,$\text{E'(t+1) - E'(t) <0}$ If Δ = -1, then the above proposition can be proved in exactly the same manner. That is, it can be proved that this multi-level neural network operates so as constantly to lower the energy. Accordingly, in the above apparatus, if a proper initial value is input to N multi-level neurons and the multi-level neural network is operated, the calculations performed by this neural network will converge to b(n).

While the above-described multi-level neural network was applied to the situation in which the input analogue signal is a one-dimensional signal such as an audio signal, the apparatus may be expanded in a two-dimensional fashion, so that the multi-level neural network system of the present invention can also be applied to image processing.

## Claims

1. A neural network quantizer comprising:
a plurality of multi-level neurons (30 to 3N-1), each neuron being responsive to an input analogue signal to generate an output analogue value having one of a plurality of possible non-zero amplitude levels;
means (20 to 2N-1) for supplying respective sampled input analogue signals to respective ones of said neurons (30 to 3N-1);
means (40,0 to 4N-1,N-1) for weighting said output analogue values by weighting coefficients to generate weighted analogue values;
means (40,0 to 4N-1,N-1) for feeding back each of said weighted analogue values from the respective one of said neurons (3) to all of said neurons (3);
means (32) for comparing the weighted analogue values fed back with the respective ones of said sampled input analogue signals and providing corresponding compared results; and
means (34,35,36) for correcting the output values of said neurons (3) in response to said compared results, so that, when the compared results are converged within a predetermined range, the output values of said neurons (30 to 3N-1) are produced to quantize said input analogue signals; characterised in that
said weighting coefficients correspond to a transformation from a frequency domain into a temporal domain of a band pass window function for a desired frequency band within said sampled input analogue signals.

2. A neural network quantizer as claimed in claim 1, wherein
each neuron (30 to 3N-1) includes comparing means (34,35) for comparing respective ones of said weighted analogue values and said sampled input analogue signals so as to form a comparison signal, means (36) for processing said comparison signal so as to form a respective output signal, and means (37) for converting the respective output signal to an output analogue value for supply to said weighting means (40,0 to 4N-1,N-1) along with the output analogue values of other said neuron (30 to 3N-1) so as to form said respective weighted analogue values; and further comprising
means (50 to 5N-1) for obtaining the quantized analogue signals from said output analogue values of said neuron (30 to 3N-1) when the comparison signals converge to values which lie within a predetermined range (-λ to +λ).

3. A neural network quantizer according to claim 2 wherein the respective output signal from each said means (37) for converting is fed back through said weighting means (40,0 to 4N-1,N-1) so as to form the respective weighted analogue signals to the respective one of said neurons (30 to 3N-1) and to the other remaining said neuron means (30 to 3N-1).

4. A neural network quantizer according to claim 3 including a plurality of means (5) for latching said output analogue value, and in response to a sampling pulse for supplying the latched output signals therefrom.

5. A neural network quantizer according to claim 3 wherein each said comparing means (32) includes subtraction means (32) for subtracting the respective sampled analogue signal from the respective weighted analogue value.

6. A neural network quantizer according to claim 3 wherein said means (36) for processing said comparison signal includes up and down counter means (36) for increasing and decreasing amplitudes of the respective output analogue values.

## Patentansprüche

1. Quantisierer mit neuronalem Netz
mit einer Mehrzahl von Multipegel-Neuronen (30 bis 3N-1), wobei jedes Neuron auf ein analoges Eingangssignal anspricht und ein analoges Ausgangssignal erzeugt, das einen von mehreren möglichen, von Null verschiedenen Amplitudenpegeln aufweist,
mit Mitteln (20 bis 2N-1) zum Zuführen von abgetasteten analogen Eingangssignalen zu entsprechendes Exemplaren der genannten Neuronen (30 bis 3N-1),
mit Gewichtungsmitteln (40,0 bis 4N-1, N-1) zum Gewichten der analogen Ausgangswerte durch Gewichtungskoeffizienten zur Erzeugung von gewichteten analogen Werten,
mit Mitteln (40,0 bis 4N-1, N-1) zum Rückkoppeln jedes der gewichteten analogen Werte aus dem entsprechenden Exemplar der Neuronen (3) zu allen Neuronen (3),
mit Mitteln (32) zum Vergleichen der rückgekoppelten gewichteten analogen Werte mit den entsprechenden Exemplaren der abgetasteten analogen Eingangssignale und zur Lieferung entsprechender Vergleichsergebnisse und
mit Mitteln (34, 35, 36) zum Korrigieren der Ausgangswerte der Neuronen (3) nach Maßgabe der Vergleichsergebnisse in der Weise, daß dann, wenn die Vergleichsergebnisse innerhalb eines vorbestimmten Bereichs konvergieren, die Ausgangswerte der Neuronen (30 bis 3N-1) erzeugt werden, um die analogen Eingangssignale zu quantisieren,
**dadurch gekennzeichnet,**
daß die Gewichtungskoeffizienten einer Transformation aus einer Frequenzdomäne in eine Zeitdomäne einer Bandpaß-Fensterfunktion für ein gewünschtes Frequenzband in den genannten abgetasteten analogen Eingangssignalen entsprechen.

2. Quantisierer mit neuronalem Netz nach Anspruch 1,
bei dem jedes Neuron (30 bis 3N-1) Vergleichermittel (34, 35) zum Vergleichen entsprechender Exemplare der gewichteten analogen Werte und der abgetasteten analogen Eingangssignale aufweist, um ein Vergleichssignal zu erzeugen, ferner Mittel (36) zum Verarbeiten des Vergleichssignals, um ein entsprechendes Ausgangssignal zu erzeugen, sowie Umwandlungsmittel (37) zum Umwandeln des jeweiligen Ausgangssignals in einen analogen Ausgangswert, der zusammen mit den analogen Ausgangswerten anderer Neuronen (30 bis 3N-1) den genannten Gewichtungsmitteln (40,0 bis 4N-1, N-1) zugeführt wird, um die jeweiligen gewichteten analogen Werte zu erzeugen,
wobei ferner Mittel (50 bis 5N-1) vorgesehen sind zur Gewinnung der quantisierten analogen Signale aus den analogen Ausgangswerten des Neurons (30 bis 3N-1), wenn die Vergleichssignale zu Werten konvergieren, die innerhalb eines vorgegebenen Bereichs (-λ bis +λ) liegen.

3. Quantisierer mit neuronalem Netz nach Anspruch 2, bei dem das jeweilige Ausgangssignal der genannten Umwandlungsmittel (37) über die Gewichtungsmittel (40,0 bis 4N-1, N-1) zu dem betreffenden Exemplar der Neuronen (30 bis 3N-1) und zu den verbleibenden anderen Neuronen (30 bis 3N-1) rückgekoppelt wird, um die jeweiligen gewichteten analogen Signale zu bilden.

4. Quantisierer mit neuronalem Netz nach Anspruch 3 mit einer Mehrzahl von Haltemitteln (5) zum Halten des analogen Ausgangswerts und zur Ausgabe der gehaltenen Ausgangssignale aus diesen nach Maßgabe eines Abtastimpulses.

5. Quantisierer mit neuronalem Netz nach Anspruch 3, bei dem jedes der genannten Vergleichermittel (32) eine Subtraktionseinrichtung (32) zum Subtrahieren des jeweiligen abgetasteten analogen Signals von dem jeweiligen gewichteten analogen Wert aufweist.

6. Quantisierer mit neuronalem Netz nach Anspruch 3, bei dem die Mittel (36) zum Verarbeiten des Vergleichssignals eine Aufwärts/Abwärts-Zähleinrichtung (36) zum Vergrößern und Verkleinern der Amplituden der betreffenden analogen Ausgangswerte enthalten.

## Revendications

1. Quantificateur à réseau neuronal, comprenant :
une pluralité de neurones multiniveau (3₀ à 3_{N-1}), chaque neurone répondant à un signal analogique d'entrée en produisant une valeur analogique de sortie ayant un niveau parmi une pluralité de niveaux possibles d'amplitude non nulle ;
des moyens (2₀ à 2_{N-1}) servant à fournir des signaux analogiques d'entrée échantillonnés respectifs à des neurones respectifs parmi lesdits neurones (3₀ à 3_{N-1}) ;
des moyens (4_{0,0} à 4_{N-1,N-1}) servant à pondérer lesdites valeurs analogiques de sortie à l'aide de coefficients de pondération afin de produire des valeurs analogiques pondérées ;
des moyens (4_{0,0} à 4_{N-1,N-1}) servant à renvoyer en réaction chacune desdites valeurs analogiques pondérées de l'un, respectif, desdits neurones (3) à l'ensemble desdits neurones (3) ;
un moyen (32) servant à comparer les valeurs analogiques pondérées qui ont été renvoyées avec les signaux respectifs parmi lesdits signaux analogiques d'entrée échantillonnés et à fournir des résultats comparés correspondants ; et
des moyens (34, 35, 36) servant à corriger les valeurs de sortie desdits neurones (3) en fonction desdits résultats comparés, si bien que, lorsque les résultats comparés convergent à l'intérieur d'un intervalle prédéterminé, les valeurs de sortie desdits neurones (3₀ à 3_{N-1}) sont produites pour quantifier lesdits signaux analogiques d'entrée ;
caractérisé en ce que lesdits coefficients de pondération correspondent à une transformation d'un domaine de fréquence à un domaine temporel d'une fonction de fenêtre passe-bande pour une bande de fréquence voulue à l'intérieur desdits signaux analogiques d'entrée échantillonnés.

2. Quantificateur à réseau neuronal selon la revendication 1, où : chaque neurone (3₀ à 3_{N-1}) comporte des moyens de comparaison (34, 35) servant à comparer des valeurs respectives desdites valeurs analogiques pondérées et lesdits signaux analogiques d'entrée échantillonnés afin de former un signal de comparaison, un moyen (36) servant à traiter ledit signal de comparaison afin de former un signal de sortie respectif, et un moyen (36) servant à convertir le signal de sortie respectif en une valeur analogique de sortie pour la fournir auxdits moyens de pondération (4_{0,0} à 4_{N-1,N-1}) en même temps que les valeurs analogiques de sortie d'autres dits neurones (3₀ à 3_{N-1}) de façon à former lesdites valeurs analogiques pondérées respectives, et comprenant en outre :
des moyens (5₀ à 5_{N-1}) permettant d'obtenir les signaux analogiques quantifiés à partir desdites valeurs analogiques de sortie desdits neurones (3₀ à 3_{N-1}) lorsque les signaux de comparaison convergent vers des valeurs qui se trouvent à l'intérieur d'un intervalle prédéterminé (de -λ à +λ).

3. Quantificateur à réseau neuronal selon la revendication 2, où le signal de sortie respectif venant de chaque dit moyen (37) de conversion est renvoyé, via lesdits moyens de pondération (4_{0,0} à 4_{N-1,N-1}), de façon à former les signaux analogiques pondérés respectifs, à l'un, respectif, desdits neurones (3₀ à 3_{N-1}) et aux autres neurones restants parmi desdits neurones (3₀ à 3_{N-1}).

4. Quantificateur à réseau neuronal selon la revendication 3, comportant une pluralité de moyens (5) servant à verrouiller ladite valeur analogique de sortie, et, en réponse à une impulsion d'échantillonnage, à fournir les signaux de sortie verrouillés.

5. Quantificateur à réseau neuronal selon la revendication 3, où chaque dit moyen de comparaison (32) comporte un moyen de soustraction (32) servant à soustraire le signal analogique échantillonné respectif de la valeur analogique pondérée respective.

6. Quantificateur à réseau neuronal selon la revendication 3, où ledit moyen (36) servant à traiter ledit signal de comparaison comporte un moyen compteur ascendant-descendant (36) servant à augmenter et diminuer les amplitudes des valeurs analogiques de sortie respectives.
